# EUROPEAN PATENT APPLICATION

(11) **EP 4 636 831 A1**
(43) Date of publication of application: **22.10.2025**
(21) Application number: 23917048.3
(22) Date of filing: 11.09.2023
(51) Int. Cl.: H01L 31/0224, H01L 31/068

(54) **SOLAR CELL**

(30) Priority: 16.01.2023 CN 202320114223 U
(71) Applicant: Trina Solar Co., Ltd, Changzhou, Jiangsu 213031 (CN)
(72) Inventor: XU, Guanchao, hangzhou, Jiangsu 213031 (CN); ZHANG, Xueling, hangzhou, Jiangsu 213031 (CN); CHEN, Yifeng, hangzhou, Jiangsu 213031 (CN)
(74) Representative: Canzler & Bergmeier Patentanwälte Partnerschaft mbB
(86) International application number: PCT/CN2023/117947
(87) International publication number: WO 2024/152580

(57) **Abstract**

Embodiments of the present disclosure relate to, but are not limited to, a solar cell (100), including: a substrate (110); a first polarity emitter (120) in contact with the substrate (110) and having the same polarity as the substrate (110); a second polarity emitter (130) in contact with the substrate (110) and having an opposite polarity to the substrate (110); and a first polarity metal gate line (140) in contact with the first polarity emitter (120), where the first polarity metal gate line (140) only penetrates an insulating material (170) locally to contact the first polarity emitter (120), while a part of other regions of the first polarity metal gate line (140) covers the second polarity emitter (130) with the insulating material (170) in between and is insulated from the second polarity emitter (130) via the insulating material (170).

## Description

### TECHNICAL FIELD

Embodiments of the present disclosure relate to, but are not limited to, a solar cell.

### BACKGROUND

An all-back electrode solar cell (hereinafter sometimes referred to as "all-back electrode cell") includes a substrate and emitters of two polarities, i.e., an emitter with the same polarity as the substrate and an emitter with an opposite polarity to the substrate, on a back surface of the substrate, as well as metal gate lines of two polarities to contact the emitters of the two polarities, respectively, so that carriers collected by the solar cell are guided out to an external circuit. For a typical all-back electrode cell, the metal gate lines of the cell cover the emitters of the same polarities, respectively. That is, the metal gate line with a first polarity covers the emitter with the first polarity, and the metal gate line with a second polarity covers the emitter with the second polarity.

This metal contact design scheme has the following disadvantages. An emitter with the same polarity as the substrate will give rise to parasitic absorption and more recombination, so that a smaller area fraction of this emitter leads to a higher conversion efficiency of the cell. However, in such an all-back electrode cell design, the emitter with a polarity opposite to the substrate generally has a width the same as, or slightly greater than, the metal gate line of that polarity, which limits the increase in the area fraction of the emitter with that polarity, and therefore limits the improvement in the conversion efficiency of the solar cell.

### SUMMARY

The present disclosure is made to solve the above problems.

The present application provides a solar cell, including: a substrate; a first polarity emitter in contact with the substrate and having the same polarity as the substrate; a second polarity emitter in contact with the substrate and having an opposite polarity to the substrate; and a first polarity metal gate line in contact with the first polarity emitter, wherein the first polarity metal gate line only penetrates an insulating material locally to contact the first polarity emitter, while a part of other regions of the first polarity metal gate line covers the second polarity emitter with the insulating material in between and is insulated from the second polarity emitter via the insulating material.

In the solar cell of the present application, the first polarity metal gate line is provided to contact the first polarity emitter only locally, so that the area fraction of the first polarity emitter with the same polarity as the substrate is minimized, i.e., most of the area is occupied by the second polarity emitter with the opposite polarity to the substrate, which can inhibit the generation of parasitic absorption and more recombination, and further improve the conversion efficiency of the solar cell.

In an embodiment of the present application, a contact region of the first polarity metal gate line penetrating the insulating material and in contact with the first polarity emitter may have an area equal to or smaller than a part of the first polarity emitter below the first polarity metal gate line. In the case where the contact region has an area smaller than the part of the first polarity emitter below the first polarity metal gate line, other parts of the first polarity emitter not in contact with the first polarity metal gate line may remain insulated from the first polarity metal gate line via the insulating material.

In an embodiment of the present application, a contact region of the first polarity metal gate line penetrating the insulating material and in contact with the first polarity emitter may have a substantially rectangular shape, the first polarity emitter may have a substantially rectangular shape, and a contact length of the contact region in a length direction may be equal to or smaller than a first polarity emitter length of the first polarity emitter in the length direction. The first polarity emitter and the second polarity emitter may be separated by a neutral region in both a length direction and a width direction. The first polarity emitter may include a plurality of first polarity emitter parts of the same size enclosed in the second polarity emitter, each of which may be separated from the second polarity emitter by the neutral region in both the length direction and the width direction. The first polarity emitter part may have a substantially rectangular, substantially square, or substantially circular shape. The solar cell may further include a plurality of second polarity metal gate lines in contact with the second polarity emitter, wherein a plurality of first polarity metal gate lines may be provided, and the plurality of first polarity metal gate lines and the plurality of second polarity metal gate lines may both extend along the length direction, and may be arranged alternately and substantially parallel to each other in the width direction. Each first polarity metal gate line may contact the plurality of first polarity emitter parts at a plurality of local positions along the length direction. A width of each second polarity metal gate line in the width direction may be greater than a width of each first polarity metal gate line in the width direction.

In an embodiment of the present application, a thickness of the first polarity emitter in a thickness direction may be less than or equal to a thickness of the second polarity emitter in the thickness direction.

### BRIEF DESCRIPTION OF DRAWINGS

FIG. 1 is a partial top view of a back surface of a solar cell (also referred to as an all-back electrode solar cell) according to an embodiment of the present application; and
FIG. 2 is a sectional view of the all-back electrode solar cell of FIG. 1 taken along line A-A.

### DETAIL DESCRIPTION OF EMBODIMENTS

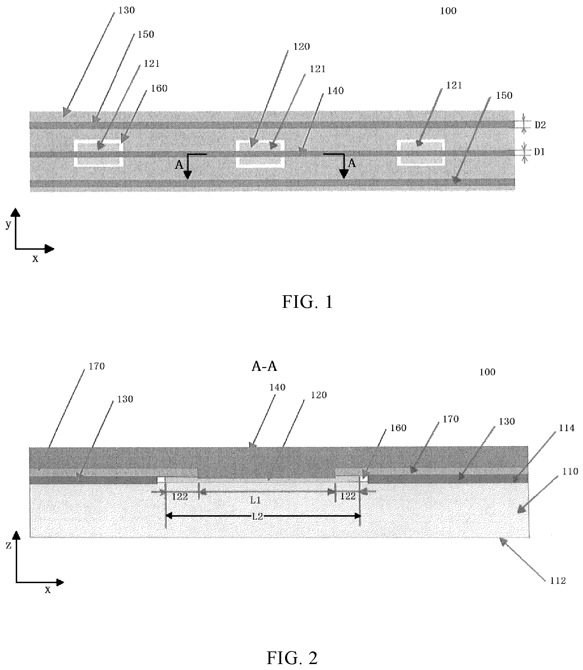

An all-back electrode solar cell 100 according to a specific embodiment of the present application will be described in detail below with reference to FIGs. 1 and 2.

FIG. 1 is a partial top view of a back surface of an all-back electrode solar cell 100 according to a specific embodiment of the present application, and FIG. 2 is a partial sectional side view of the all-back electrode solar cell 100 of FIG. 1 taken along line A-A.

As shown in the figures, the all-back electrode solar cell 100 includes a substrate 110 (FIG. 2) including two opposite surfaces in a z-direction. In this embodiment, one surface facing the sun is defined as a front surface 112, while the other surface facing away from the sun is defined as a back surface 114. For convenience of description, three directions x, y and z are introduced, where the x-direction is a length direction of the all-back electrode solar cell 100, the y-direction is a width direction of the all-back electrode solar cell 100, and the z-direction is a thickness direction of the all-back electrode solar cell 100. In this embodiment, the length direction is a direction in which the first polarity metal gate line 140 (which is described in detail below) generally extends and which is substantially parallel to the back surface 114, the width direction is substantially orthogonal to the length direction and also substantially parallel to the back surface 114, and the thickness direction is a direction substantially orthogonal to the back surface 114 and therefore substantially orthogonal to both the length direction and the width direction.

The all-back electrode solar cell 110 further includes a first polarity emitter 120 and a second polarity emitter 130, which are both provided on the back surface 114 of the substrate 110 in this embodiment. As shown in FIG. 2, the first polarity emitter 120 is in contact with the substrate 110 and has the same polarity as the substrate 110, while the second polarity emitter 130 is in contact with the substrate 110 and has the opposite polarity to the substrate 110. A thickness of the first polarity emitter 120 in the z-direction may be less than or equal to a thickness of the second polarity emitter 130 in the z-direction. The first polarity emitter 120 includes a plurality of first polarity emitter parts 121 (three are exemplarily shown in FIG. 1) enclosed in the second polarity emitter 130, each of which is separated from the second polarity emitter 130 by a neutral region 160 in both the x-direction and the y-direction. In this embodiment, each of the three first emitter parts 121 is illustrated as having a substantially rectangular shape, but it may also have other shapes, such as a substantially square shape, a substantially circular shape, and the like. It will be understood by those skilled in the art that the number of first emitter parts 121 in the embodiment is merely shown for convenience of illustration, and the specific number of first emitter parts 121 may be set as needed without particular limitations.

On the back surface 114, the all-back electrode solar cell 100 further includes a first polarity metal gate line 140 in contact with the first polarity emitter 120, and a second polarity metal gate line 150 in contact with the second polarity emitter 130. Additionally, the back surface 114 further includes an insulating material 170 disposed below a part of the first polarity metal gate line 140 and configured to separate the first polarity metal gate line 140 from the second polarity emitter 130 (and possibly the first polarity emitter 120), as will be described in more detail below. A plurality of first polarity metal gate lines 140 and a plurality of second polarity metal gate lines 150 may be included, both extending in the x-direction and being arranged alternately and substantially parallel to each other in the y-direction. The partial view of FIG. 1 only shows one first polarity metal gate line 140, and two second polarity metal gate lines 150 arranged substantially parallel at both sides of the one first polarity metal gate line 140 in the y-direction and spaced apart from each other. Furthermore, in this embodiment, a width D2 of the second polarity metal gate line 150 in the y-direction is greater than a width D1 of the first polarity metal gate line 140 in the y-direction.

The plurality of first polarity emitter parts 121 are disposed below the one first polarity metal gate line 140 in the x-direction. Moreover, the first polarity metal gate line 140 penetrates the insulating material 170 to contact the first polarity emitter 120 (the plurality of first polarity emitter parts 121) only at positions corresponding to the first polarity emitter parts 121, while a part of other regions of the first polarity metal gate line 140 covers the second polarity emitter 130 with the insulating material 170 in between at the back surface of the all-back electrode solar cell 100, and is insulated from the second polarity emitter 130 via the insulating material 170, as shown in FIG. 2.

Specifically, as shown in FIG. 2, in this embodiment, the part of other regions of the first polarity metal gate line 140 refers to: a part of other regions other than regions corresponding to other parts 122 and the neutral region 160, where the other regions are regions do not penetrate the insulating material 170, and the other parts 122 are parts of the first polarity emitter 120 not in contact with the first polarity metal gate line 140. In other words, other parts in other regions of the first polarity metal gate line 140 except the above-mentioned part cover the neutral region 160 and other parts 122 (if any) via the insulating material 170.

Furthermore, as shown in FIG. 2, a contact length L1 in the x-direction of a contact region of the first polarity metal gate line 140 penetrating the insulating material 170 and in contact with the first polarity emitter 120 (the plurality of first polarity emitter parts 121) may be equal to or less than a first polarity emitter length L2 in the x-direction of the first polarity emitter 120 (the first polarity emitter parts 121). In this embodiment, the contact length L1 is less than the first polarity emitter length L2. In other words, a contact region of the first polarity metal gate line 140 penetrating the insulating material 170 and in contact with the first polarity emitter 120 (i.e., the plurality of first polarity emitter parts 121) may have an area equal to or smaller than (smaller than in this embodiment) a part of the first polarity emitter 120 (the plurality of first polarity emitter parts 121) below the first polarity metal gate line 140. In the case of the contact region has an area smaller than the part of the first polarity emitter 120 below the first polarity metal gate line 140, other parts 122 of the first polarity emitter 120 (the plurality of first polarity emitter parts 121) not in contact with the first polarity metal gate line 140 remain insulated from the first polarity metal gate line 140 via the insulating material 170.

In the all-back electrode solar cell 100 of the present application, the first polarity metal gate line 140 is provided to contact the first polarity emitter 120 only locally, so that the area fraction of the first polarity emitter 120 with the same polarity as the substrate 110 is minimized, i.e., most of the area is occupied by the second polarity emitter 130 with the opposite polarity to the substrate 110, which can inhibit the generation of parasitic absorption and more recombination, and further improve the conversion efficiency of the cell.

Finally, it should be noted that: the above embodiments are only used to illustrate the technical solutions of the present disclosure, and not to limit the present application. For example, the three directions x, y and z are merely used to describe the present application and should not be used to limit the scope of the present application. Although the present disclosure has been described in detail with reference to the foregoing embodiments, it should be understood by those of ordinary skill in the art that: the technical solutions described in the foregoing embodiments may still be modified, or some or all of the technical features therein may be equivalently replaced; such changes or substitutions do not make the corresponding technical solutions depart from the spirit and scope of the embodiments of the present disclosure.

### List of reference signs:

100: all-back electrode solar cell
110: sub strate
120: first polarity emitter
121: first polarity emitter part
122: other parts of the first polarity emitter not in contact with the first polarity metal gate line 140
130: second polarity emitter
140: first polarity metal gate line
150: second polarity metal gate line
160: neutral region
170: insulating material
D1: width of the first polarity metal gate line 140 in the y-direction
D2: width of the second polarity metal gate line 150 in the y-direction
L1: length of the contact region of the first polarity metal gate line 140 in contact with the first polarity emitter 120 in the x-direction
L2: first polarity emitter length.

## Claims

1. A solar cell (100), comprising:
a substrate (110);
a first polarity emitter (120) in contact with the substrate (110) and having the same polarity as the substrate (110);
a second polarity emitter (130) in contact with the substrate (110) and having an opposite polarity to the substrate (110); and
a first polarity metal gate line (140) in contact with the first polarity emitter (120), wherein
the first polarity metal gate line (140) only penetrates an insulating material (170) locally to contact the first polarity emitter (120), while a part of other regions of the first polarity metal gate line (140) covers the second polarity emitter (130) with the insulating material (170) in between and is insulated from the second polarity emitter (130) via the insulating material (170).

2. The solar cell (100) according to claim 1, wherein a contact region of the first polarity metal gate line (140) penetrating the insulating material (170) and in contact with the first polarity emitter (120) has an area equal to a part of the first polarity emitter (120) below the first polarity metal gate line (140).

3. The solar cell (100) according to claim 1, wherein a contact region of the first polarity metal gate line (140) penetrating the insulating material (170) and in contact with the first polarity emitter (120) has an area smaller than a part of the first polarity emitter (120) below the first polarity metal gate line (140).

4. The solar cell (100) according to claim 3, wherein other parts (122) of the first polarity emitter (120) not in contact with the first polarity metal gate line (140) remain insulated from the first polarity metal gate line (140) via the insulating material (170).

5. The solar cell (100) according to claim 1, wherein a contact region of the first polarity metal gate line (140) penetrating the insulating material (170) and in contact with the first polarity emitter (120) has a substantially rectangular shape, the first polarity emitter (120) has a substantially rectangular shape, and a contact length (L1) of the contact region in a length direction is equal to a first polarity emitter length (L2) of the first polarity emitter (120) in the length direction.

6. The solar cell (100) according to claim 1, wherein a contact region of the first polarity metal gate line (140) penetrating the insulating material (170) and in contact with the first polarity emitter (120) has a substantially rectangular shape, the first polarity emitter (120) has a substantially rectangular shape, and a contact length (L1) of the contact region in a length direction is less than a first polarity emitter length (L2) of the first polarity emitter (120) in the length direction.

7. The solar cell (100) according to claim 1, wherein
the first polarity emitter (120) and the second polarity emitter (130) are separated by a neutral region (160) in both a length direction and a width direction.

8. The solar cell (100) according to claim 7, wherein
the first polarity emitter (120) comprises a plurality of first polarity emitter parts (121) of the same size enclosed in the second polarity emitter (130), each of which is separated from the second polarity emitter (130) by the neutral region (160) in both the length direction and the width direction.

9. The solar cell (100) according to claim 8, wherein
each of the first polarity emitter parts (121) has a substantially rectangular shape.

10. The solar cell (100) according to claim 8, wherein
each of the first polarity emitter parts (121) has a substantially square shape.

11. The solar cell (100) according to claim 8, wherein
each of the first polarity emitter parts (121) has a substantially circular shape.

12. The solar cell (100) according to any of claims 8 to 11, further comprising a plurality of second polarity metal gate lines (150) in contact with the second polarity emitter (130), wherein a plurality of first polarity metal gate lines (140) are provided, and the plurality of first polarity metal gate lines (140) and the plurality of second polarity metal gate lines (150) both extend substantially along the length direction, and are arranged alternately and substantially parallel to each other in the width direction.

13. The solar cell (100) according to claim 12, wherein each first polarity metal gate line (140) contacts the plurality of first polarity emitter parts (121) at a plurality of local positions along the length direction.

14. The solar cell (100) according to claim 12, wherein a width (D2) of each second polarity metal gate line (150) in the width direction is greater than a width (D1) of each first polarity metal gate line (140) in the width direction.

15. The solar cell (100) according to claim 1, wherein
a thickness of the first polarity emitter (120) in a thickness direction is less than or equal to a thickness of the second polarity emitter (130) in the thickness direction.
